(19) Europäisches Patentamt
European Patent Office
Office européen des brevets

(11) **EP 2 317 600 A1**

(12) **EUROPEAN PATENT APPLICATION**

(43) Date of publication:
**04.05.2011 Bulletin 2011/18**

(51) Int Cl.:
*H01P 1/02* (2006.01)  *H01P 3/04* (2006.01)
*H01P 3/02* (2006.01)  *H05K 1/02* (2006.01)

(21) Application number: **09174761.8**

(22) Date of filing: **02.11.2009**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**

(71) Applicant: **NXP B.V.**
**5656 AG Eindhoven (NL)**

(72) Inventor: **Tesson, Olivier**
**14906 Caen Cedex 05 (FR)**

(74) Representative: **Krott, Michel**
**High Tech Campus 32**
**5656 AE Eindhoven (NL)**

(54) **Electronic circuit having multiple transmission lines**

(57)    An electronic circuit (100), having multiple transmission lines (152, 102). A first and second transmission line (152,102) have a bend (156) where the transmission lines make an angle. The angles have the same magnitude and the same orientation. The first and second transmission line (152, 102) cross (102), and their electrical lengths are equal. Relative phase between multiple interrelated signals transmitted across the multiple transmission lines is preserved as they traverse the bends.

100

**Fig 3**

EP 2 317 600 A1

**Description**

FIELD OF THE INVENTION

The invention relates to an electronic circuit, having multiple transmission lines supported by a substrate, for transport of information in the form of multiple interrelated signals across the electronic circuit, wherein: a first transmission line of the multiple transmission lines has a first starting point, a first terminating point, and a first bend where the first transmission line makes a first angle, a second transmission line of the multiple transmission lines has a second starting point, a second terminating point, and a second bend where the second transmission line makes a second angle, the first and second angle have the same magnitude and the same orientation with respect to the substrate, the first and second transmission lines run parallel at the first and second starting points, and run parallel at the first and second terminating points.

BACKGROUND OF THE INVENTION

Silicon chips that are used in high-frequency applications often need to transport high frequency signals from a first area of the chip to a second. Radio frequency (RF) and microwave frequency applications, such as mobile phones, are an example of a high frequency application. RF covers a range of electromagnetic frequencies used for radio transmissions, typically, including the frequency band from 100 kHz to 100 GHz.
Transport of high frequency signals is especially important when the passive components needed for RF, such as coils, are integrated with other digital components into a single 'system-in-package' solution. Techniques known from the system-on-chips industry, in which heterogeneous digital circuits are combined, are not always applicable, because of the peculiarities of high frequency signals.
Two problems are associated in particular with the transport of high frequency signals. First of all, a transmission line used for the transport of the signal may function as an antenna, thereby causing unintended RF radiation. The unintended RF radiation may interfere with the handling of regular RF radiation. The performance of the silicon chip is thereby influenced in a negative way, typically by introducing noise.
A second problem is related to the transmission line functioning as an antenna. If the transmission line starts receiving signals from components, which happen to be close to the transmission line, then the received signals will distort the transported signals, since the received signal is typically different from the transported signal.
The prior art uses differential transmission lines to alleviate these two problems. A differential transmission line comprises two transmission lines: a first transmission line, and a second transmission line. The two transmission lines run parallel and close to each other. The two transmission lines carry the same signal but of opposite polarity. At the destination of the differential transmission line, the two transported signals are subtracted from each other so that once again a single signal remains. Since the signals are of opposite polarity, the subtraction does cancel the two signals out.
This measure has two effects. First, a signal which is unintentionally transmitted by the first transmission line tends to be substantially opposite to a signal which is transmitted unintentionally by the second transmission line, since the first transmission line runs parallel and close to the second transmission line and carries a signal of opposite polarity. Therefore, the two transmitted signals substantially cancel each other out. The problematic effect of transmission lines acting as an antenna and radiating a distorting signal is reduced.
Second, since the first transmission line runs parallel and close to the second transmission line, signals which are received unintentionally on the first transmission line tends to be substantially equal to signals which are received unintentionally on the second transmission line, after the transported signals are subtracted from each other the noise substantially cancels out.
Opposite polarity can be achieved by obtaining two signals of opposite phase.

SUMMARY OF THE INVENTION

This prior art solution, is not without problems. The floor plan of a silicon chip, i.e., the 'layout', comprises many components, and must often be optimized for many, sometimes, conflicting constraints. Accordingly, it will often not be possible to route a differential transmission line along a straight path from the first area to the second area. As a result, the two transmission lines are at least somewhat different and the positive effects of differential transmission lines described above are reduced.
Figure one, shows a differential transmission line from a region A to a region B, which is not in a straight line. The electrical length from A to B along a first one of the transmission lines is not equal to an electrical length from A to B along a second one of the transmission lines. Accordingly, it two signals that are of opposite polarity were transmitted across the first and the second transmission line respectively they would undergo a different phase shift and will not stay in opposite polarity. An increase in unwanted radiation and an increase in the transmission line's sensitivity to noise is the result.
In the prior art, attempts have been made to mitigate this problem. US patent application 20070063782, 'Differential transmission line', included herein by reference, discloses a known differential transmission line. The known differential transmission line includes: a substrate; a ground conductor layer formed on a rear side of the substrate; and a first signal conductor and a second signal conductor disposed in parallel to each other on a front side of the substrate. The first signal conductor and the ground conductor layer compose a first transmission line, whereas the second signal conductor and the ground conductor layer compose a second transmission line. The first transmission line and the second transmission line compose a differential transmission line. The differential transmission line includes a curved region with a straight region being connected to each end of the curved region. In the ground conductor layer in the curved region, a plurality of slots which are orthogonal to a local transmission direction of signals in the curved region are formed, the slots being connected to one another on the inner side of the curvature.

The slots reduce the tendency of signals, which are transmitted through the curved region of the transmission line move, shift with respect to each other, so that the signals are not longer of opposite polarity.

The use of slots however can only reduce the phase shift effects of the bend. Moreover, an additional component is needed across a region of the layout. This increases the complexity of the layout.

It would be advantageous to have a way to route a high frequency signal from a first area of a chip to a second area of a silicon chip, not in a straight line, without transmitting or receiving noise, and without adding large components to a curved regions of a signal carrier.

This and other objects are achieved by the electronic circuit according to the invention. In the electronic circuit according to the invention, the first transmission line crosses the second transmission line, and the electrical lengths of the first and second transmission lines are equal.

When the first and second transmission lines are used as differential transmission lines to transport signals of opposite phase, the signals will get out of opposite phase if the transmission lines have an unequal electrical length. If the signals are not in opposite phase anymore when they arrive in the target area, then the subtraction of the signals will introduce distortions in the signal. This problem is avoided if the first transmission line is of the same electrical length as the second transmission line, and the same attenuation.

The electrical length of a transmission line is measured in wavelengths and is related to the frequency of the wave and the velocity with which a signal propagates along the transmission line. The electrical length takes into account the material and nature of the metal, the via (electrical connection between a transmission line on one layer of the system to a transmission line on another layer) size between each metal.

One important factor in the determining of electrical length is the geometric length, i.e. the length measured in, e.g., meters.

If transmission lines do not cross, the transmission line which lies at the inside of a curve is shorter than the transmission line which lies at the outside of the curve. The invention makes it possible to have transmission lines bend yet retain control over their geometric length.

When two curves are crossing in addition to bending it can be avoided that one of them is longer than the other one. In particular, one can obtain bended transmission lines which are equal in electrical length by making them equal in geometric length. Note that, in particular a configuration according to the invention may be used to obtain a first and a second transmission line having a bend, which have the same geometric length.

By using a crossing point, it is avoided that the transmission lines are routed around each other, in the region around the bend. By routing around each other, one of the bends, in particular the outer bend, will be longer. By crossing the lines this is avoided. In this way, the invention provides a neutral phase bend for transmission lines.

Preferably, the electrical lengths of the multiple transmission lines are equal for practical purposes of the invention. For example, multiple related signals sent over the multiple transmission lines arrive substantially without phase shift relative to each other, i.e. the phase differences at the starting points are substantially equal to the phase differences at the terminating points, compared to a processing speed of the electronic circuit and/or the frequency of the multiple related signals.

Note that even if the distances, i.e. the geometric lengths, are equal, but the nature of the material is not the same between the lines, then the electrical resistance seen by each signal is not the same, and so the attenuation may differ. On the other hand, if the nature of the material is the same between the lines and the distances are the same then the electrical lengths will also be the same.

The invention may be applied across a wide range of the electromagnetic spectrum. For example, the invention has been found advantageous for applications that use VHF, UHF, L, S, C X and Ku bands, (respectively from the largest wavelength to the shortest one).

The frequency of the signals is an important parameter affecting the behavior of a metal interconnect, such as a transmission line. In case of propagation within a material that has a relative permittivity εr, the wavelength is given by:

$$\lambda = \frac{c}{freq \times \sqrt{\varepsilon r}}$$

Suppose, one defines a length 'd' to be equal to $\lambda/10$. If the length of the interconnect length is larger than approximately d, than the transmission line behavior must be considered. For such interconnects, the invention is especially advantageous. As a further consequence, when signals have a frequency over several GHz, say larger than 2 GHz, the invention is also particularly advantageous.

The invention, using two, three or more transmission lines can be used to transmit multiple synchronized interrelated signals, for example, differential transmissions, parallel data transport, etc. For parallel data transport, multiple data carrying signals which are synchronized to a clock are transmitted over the multiple transmission lines. The transmission lines having equal electrical length preserve the synchronicity between the signals.

In a preferred embodiment of the invention, the first transmission line crosses the second transmission line at a crossing point. The first bend of the first transmission line is between the first starting point and the crossing point. The second bend of the second transmission line is between the crossing point and the second terminating point. In a refinement of this embodiment, a further first electrical length between the first bend and the crossing point is equal to a further second electrical length between the crossing point and the second bend of the second transmission line.

A result of these features is that the distance between the first transmission line and the second transmission line before the crossing point can be equal to the distance between the first transmission line and the second transmission line after the crossing point.

Note that it is possible to have transmission lines with a different distance between them, before and after the crossing point, but this is not preferred.

An advantage of differential transmission lines is to reduce the cross-talk/noise with the substrate. The spacing between the transmission lines is advantageously determined by a target impedance of the transmission lines. This applies both to a coplanar lines (CPW) configuration, as to a microstrip configuration. Preferably, the transmission lines carry a signal that is of opposite polarity. When the differential transmission lines have reached the target area, the signals transported on the two lines are subtracted from each other.

For example, when using coplanar lines (CPW), a ground rail, may be placed on the outer side of each signal line. A virtual ground is generated in the spacing between the two signal lines, i.e. in the middle. The spacing between a transmission line and its times the spacing between a ground rail and the signal lines. The spacing of transmission lines is an important parameter, because it plays a significant role in the determination of the characteristic impedance of the system.

In a preferred embodiment, a further electronic circuit comprises a first electronic circuit as in any one of the preceding claims and a second electronic circuit as in any one of the preceding claims. The first and second electronic circuits have the same substrate.

Starting points of the multiple transmission lines, including the first and second starting points, are referred to as the collective starting points. Terminating points of the multiple transmission lines, including the first and second terminating points, are referred to as the collective terminating points.

The collective terminating points of the multiple transmission lines in the first electronic circuit are the same as the collective starting points of the multiple transmission lines in the second electronic circuit.

Note that the first and second circuit may also be otherwise connected, and they may in effect, form a single electronic circuit. For the purpose of explaining the invention however, a first bending of the transmission lines is called a first electronic circuit and a further bending of the transmission lines is called a second electronic circuit.

It is an advantage to apply the bending pattern as explained in the invention multiple times. In this way, transmission lines can be routed across the further electronic circuit in a flexible way. This gives a layout optimizer more possibilities, and hence will allow a more optimal electronic circuit to be found.

When using two transmission line configurations according to the invention in a single electronic circuit, the collective terminating points of the first electronic circuit may be connected to the collective starting points of the multiple transmission lines in the second electronic circuit.

In a preferred embodiment of further electronic circuit according to the invention, the first transmission line and the second transmission line in the first electronic circuit are connected to the first transmission line and the second transmission line in the second electronic circuit, respectively. The first transmission line crosses over the second transmission line in the first electronic circuit, and wherein the second transmission line crosses over the first transmission line in the first electronic circuit. Alternatively, the first transmission line and the second transmission line in the first electronic circuit are connected to the second transmission line and the first transmission line in the second electronic circuit, respectively.

The amount of phase shifting introduced in a crossing is much smaller than the phase shifting introduced by transmission lines of unequal length (from an electrical point of view). However, some phase shifting may nevertheless be introduced when the transmission lines cross. By having two crossing points, such that the first and second transmission line are crossed over and under an equal number of times, the amount of delay introduced for the first and the second transmission line is equal. In this way, phase shifting that may occur in the transmission line is further minimized.

At a crossing point one of the first and second transmission lines runs under the other. By crossing, say, the first transmission line under the second transmission line at a first crossing point and crossing the second transmission line under the first transmission line at the second crossing it is achieved that each transmission crosses under once, and over once. If any phase shift occurs at a crossing point, then both transmission lines have the same amount of phase shift since each line comprises the same number and type of crossing points. As a result, phase shift in the transmission lines is further reduced.

The invention also relates to multiple transmission lines.

An electronic circuit is provided having multiple transmission lines. A first and second transmission line have a bend where the transmission lines make an angle. The angles have the same magnitude and the same orientation. The first and second transmission line cross, and their electrical lengths are equal. Relative phase between multiple interrelated signals transmitted across the multiple transmission lines is preserved as they traverse the bends.

BRIEF DESCRIPTION OF THE DRAWINGS

The invention is explained in further detail by way of example and with reference to the accompanying drawings, wherein:

Figure 1 is top view of an example of differential transmission lines, connecting A and B wherein the transmission lines do not cross,

Figure 2 is diagram further illustrating the bend in the example of differential transmission lines in Figure 1,

Figure 3 is a diagram illustrating a first embodiment according to the invention,

Figure 3a is a diagram illustrating a second embodiment according to the invention,

Figure 4 is top view of a third embodiment according to the invention,

Figure 5 is a perspective view of the third embodiment according to the invention,

Figure 6 is a further top view of the third embodiment according to the invention,

Figure 7 and 8 are graphs illustrating the effect of the invention.

Throughout the Figures, similar or corresponding features are indicated by same reference numerals.

List of Reference Numerals:

| | |
|---|---|
| A | a first area |
| B | a second area |
| 100 | an electronic system |
| 101 | a second starting point |
| 102 | a second transmission line |
| 103 | a second termination point |
| 104 | a second starting portion |
| 106 | a second foot |
| 108 | a second bend |
| 109 | a second terminating portion |
| 120 | a crossing point |
| 122 | a first angle |
| 124 | a second angle |
| 126 | a third angle |
| 132 | a first distance |
| 134 | a second distance |
| 151 | a first starting point |
| 152 | a first transmission line |
| 153 | a first termination point |
| 154 | a first starting portion |
| 156 | a first bend |
| 158 | a first foot |
| 159 | a first terminating portion |
| 200 | an electronic system |
| 210 | a first bending area |
| 212,214, 222,224 | an imaginary line |
| 220 | a second bending area |
| 300 | an electronic system |
| 302 | a third transmission line |
| 306 | a first further crossing point |
| 307 | a second further crossing point |
| 322 | a third angle |
| 332 | a third distance |
| 334 | a further third distance |
| 402 | a bottom metal level |
| 404 | an upper metal level |
| 406 | a level connector |

DETAILED EMBODIMENTS

While this invention is susceptible of embodiment in many different forms, there is shown in the drawings and will herein be described in detail one or more specific embodiments, with the understanding that the present disclosure is to be considered as exemplary of the principles of the invention and not intended to limit the invention to the specific embodiments shown and described.

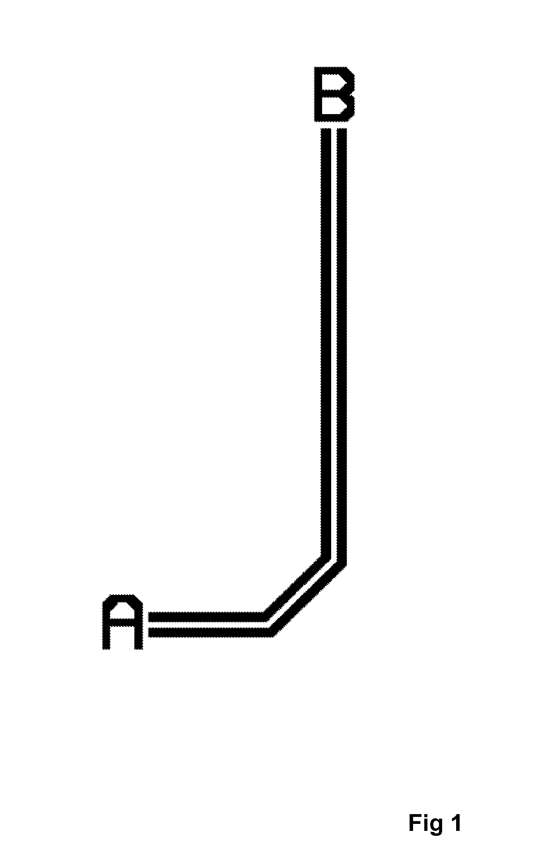

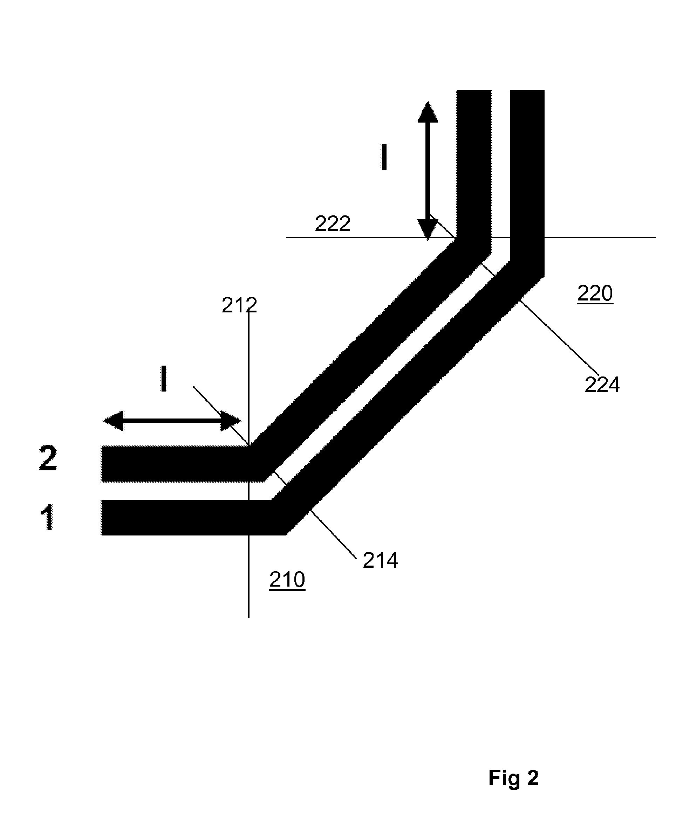

**Figure 1** shows two transmission lines, suitable for use as differential transmission lines. **Figure 2** is an enlarged view of the two bends in Figure 1, in which four imaginary lines are drawn

Two transmission lines can be used as differential transmission lines by transmitting a first signal on a first one of the two transmission lines, and transmitting a second signal on a second one of the two transmission lines, wherein the first signal and the second signal have opposite polarity, but are otherwise equal. Transmission lines are preferable within high frequency applications, e.g. in the centimeter to millimeter wave domain. In general, transmission lines become advantageous when the geometric length of the line is greater than the wavelength divided by a factor 10. Example applications include, e.g., BiCMOS, RFCMOS, etc. The invention is also useful for Passive integration with different substrate types, e.g.: Silicon, AsGa, Laminate, Ceramic (LTCC and HTCC), PCB (Printed Circuit Board), glass, etc.

In Figure 1, the areas connected by the transmission lines are marked with the letters 'A' and 'B'.

In Figure 2, the transmission lines are numbered with '1' and '2', respectively. Imaginary lines 212 and 214 indicate a first bending area 210. Imaginary lines 222 and 224 indicate a second bending area 220. Transmission line '2' bends inside of transmission line '1'. Imaginary lines 212 and 214 both run through a point on the inner edge of transmission line '2' where transmission line '2' makes an angle. Lines 212 and 214 make an angle of 45°. Imaginary lines 212 and 214 are both perpendicular with the transmission lines, but not with the same part of the transmission lines. In addition, imaginary lines 222 and 224 both run through a point on the inner edge of transmission line '2' where transmission line '2' makes an angle. Lines 222 and 224 make an angle of 45°. Imaginary lines 222 and 224 are both perpendicular with the transmission lines, but not with the same part of the transmission lines.

The regions indicated by 'I' which are bounded by imaginary lines 212 and 222 are of equal length. It can immediately be seen from the figure that transmission line '1' makes a longer bend in the regions 210 and 220. The two bends in region 210 are related by a central dilation, with as fixed point the intersection of lines 212 and 214. Accordingly, the two bends in region 210 are of unequal length. The two transmission lines shown in figure 1 and figure 2 are therefore of unequal length. This gives problems, especially for differential signals.

In general, the length of a transmission line can be measured in several ways. For example, the length can be measured along an edge can or along a midline of the transmission line. The invention applies to various ways of measuring the length.

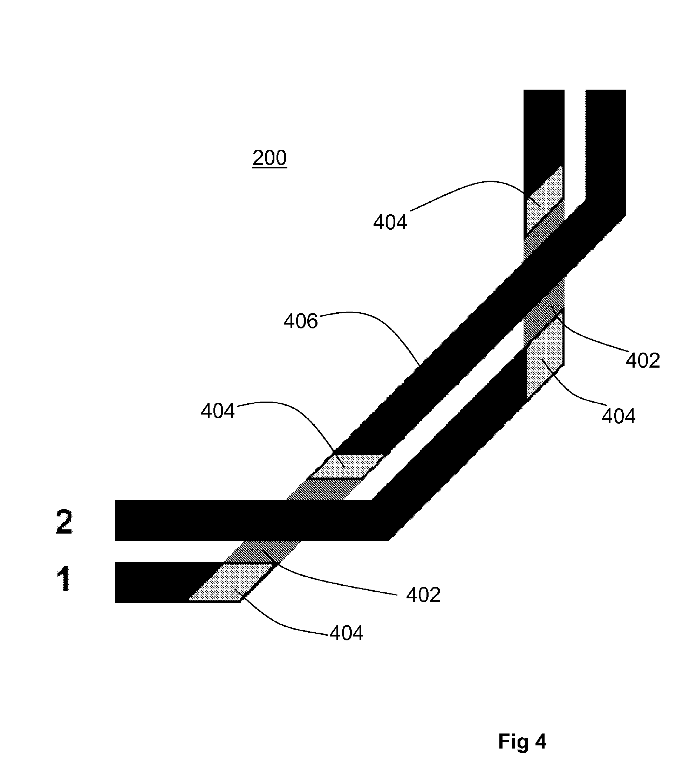

During the optimization of the layout of the electronic circuit, it is sometimes convenient to use 45° angles to optimize the topology. Two of such angles in the transmission lines are shown in Figure 1 and 2. Together the angles are 90°, that is, the transmission lines overall make a 90° angle, i.e. a right angle. This problem is exacerbated, since the implementation of the transmission lines is usually done at the end of the layout optimization, in which phase the current layout cells may be taken into account. Figures 4, 5, and 6 show a layout for configuring the transmission lines to take the same corner as in figure 1, while avoiding having two transmission lines which are not of the same electrical length.

Using the configuration depicted in Figure 1 and Figure 2 leads to a difference in the electrical length between both signals paths. A straightforward calculation shows that the inner edge of transmission line '1' is 4 x tan (22.5°) x (distance between the inner edge of transmission line '2' and the inner edge of transmission line '1'). Note that 22.5° is half the angle between line 212 and 214, that is, the angle between the bisector of lines 212 and 214 and one of lines 212 and 214.

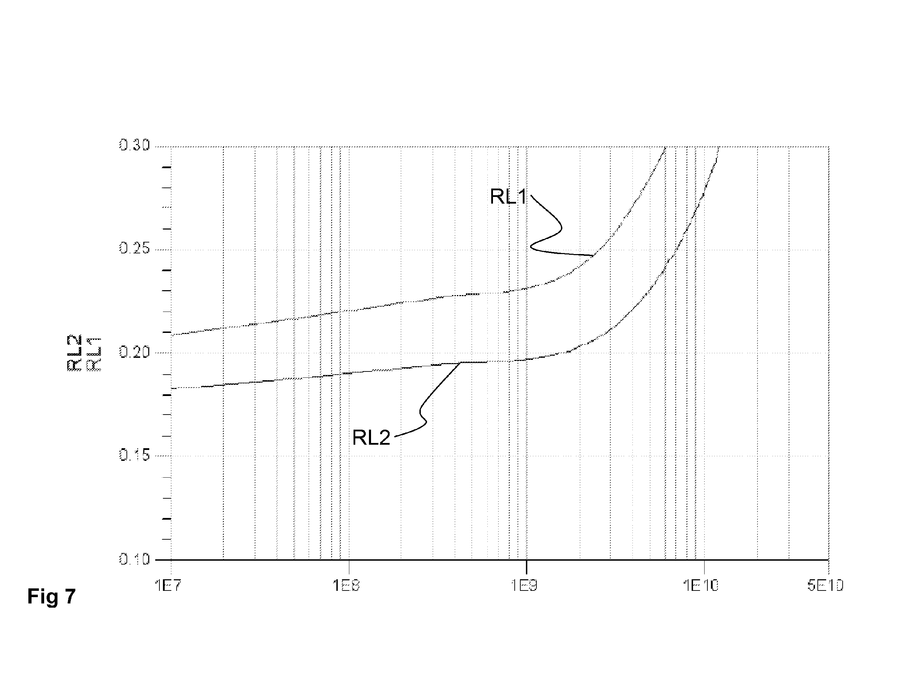

This configuration leads to a non-null phase between both signals, which is illustrated in the simulations results presented in Figure 7.

In case of differential transmission lines, such as mentioned above, the phase between both signals is equal to 180°. In a differential application both lines preferably have the same geometrical length and the same electrical impedance. If this is not the case, the bend will induce a phase between the signal on line 1 and the signal on line 2 that leads to a deviation around 180° between the signals. The application is then not truly differential. Hence, as will be described below, the bend may be designed in such a way that the geometrical lengths are the same, and that they also present the same electrical resistance in order to have the same level of signal attenuation on each line.

So to summarize, it is preferred if a phase difference between two signals at the starting points of the transmission lines is equal to 180°, and remains so after their transmission of the transmission lines. The crossing according to the invention helps to keep the phase difference constant.

Electrical length is a more general term used in the transmission line theory. In an environment where the relative permittivity is equal to $\varepsilon_{eff}$, the reference wave-length is given by:

$$\lambda_r = \frac{c_o}{freq \times \sqrt{\varepsilon_{eff}}} \quad .$$

Note that in case of non-magnetic materials the relative permeability equals 1. In this formula $c_o$ represents the speed of light (2.997925.10^8 m/s), freq the working frequency, and the electrical length is given by:

$$\theta = 2 \times \pi \times \frac{l}{\lambda_r} .$$

In this formula, I represents the geometrical length of the transmission line.

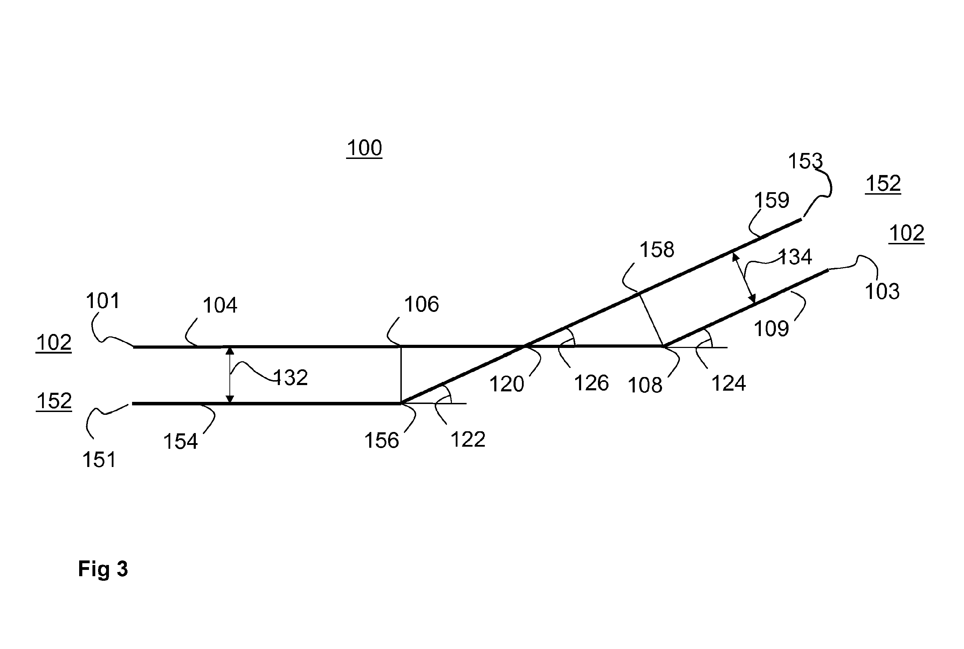

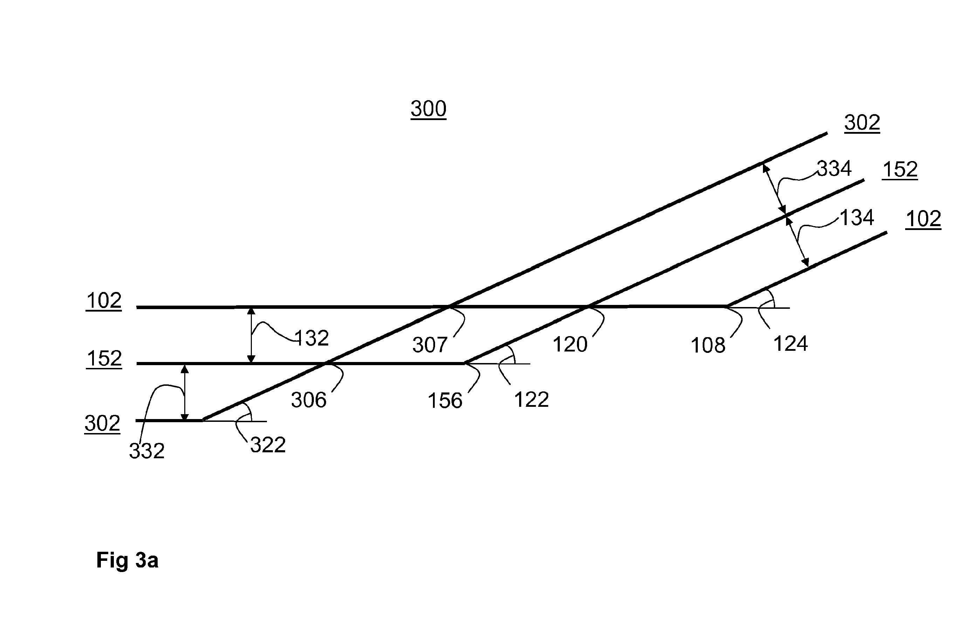

In **Figure 3,** a schematic top view of at least part of an electronic system 100 is shown. The transmission lines in electronic system 100 are in a different configuration as those in Figure 1 and 2.

Electronic system 100 comprises multiple transmission lines, shown are first transmission line 152 and second transmission line 102. Electronic system 100 is, for example, a Low temperature co-fired ceramic (LTCC), HTCC (High Temperature Co-Fired Ceramic), a Printed circuit board (PCB), glass, etc. Electronic system 100 may also be a laminate, being an organic laminate wherein the substrate is made of a mix of glass fibers and PTFE (Poly Tétra Fluoro Ethylène also known as Teflon). Preferably, the electronic system 100 comprises a substrate which supports first transmission line 152 and second transmission line 102. The multiple transmission lines may be used for the transmission of differential signals, that is, signals wherein a difference of two of the multiple transmission lines is an information carrier. The multiple transmission lines may also be used for the transport of parallel signals, e.g., clocked parallel signals.

The transmission lines each have a starting point, where the information transport is typically started. In the figure, first transmission line 152 has a first starting point 151 and a first termination point 153 and second transmission line 102 has a second starting point 101 and a second termination point 103. At first starting point 151, first transmission line 152 has a first starting portion 154. At second starting point 101, second transmission line 102 has a second starting portion 104. The terminating points are the target of the information transport. The transmission lines may also be used for bi-directional information exchange between the starting and the terminating points. At second termination point 103, second transmission line 102 has a second terminating portion 109. At first termination point 153, first transmission line 152 has a first terminating portion 159.

For example, the starting and/or terminating points may be comprised in, or coupled to, some logical circuitry, e.g. a processor, or a logical component with some programmable or dedicated function, etc. For example, the starting and/or terminating points may be comprised in, or coupled to, some analog component, e.g. a coil, a capacitance, or some combination thereof, etc.

First transmission line 152 has a first bend 156. Second transmission line 102 has a second bend 108. First transmission line 152 makes a first angle 122 at first bend 156. Second transmission line 102 makes a second angle 124 at second bend 108. first angle 122 and second angle 124 are of the same size and orientation, that is, there exists an (imaginary) translation, which maps first angle 122 to second angle 124. Angles 122 and 124 face the same direction.

Preferably, all the multiple transmission lines make an angle at a bend. Preferably, all these angles are of the same size and orientation. The transmission lines preferably run parallel. In Figure 3, second starting portion 104 runs parallel to first starting portion 154, and first terminating portion 159 runs parallel to second terminating portion 109.

A first virtual line (not shown) running through the collective starting points may be perpendicular to the multiple transmission lines at the collective starting points. This arrangement is convenient in planning in the layout of electronic system 100. A second virtual line (not shown) running through the collective terminating points, may be perpendicular to the multiple transmission lines at the collective terminating points. A length difference in the transmission lines introduced by, e.g., the first virtual line not being perpendicular to the transmission lines, may be compensated for in other ways, so as to preserve the equality of the lengths of the transmission lines. For example, such a length difference may be compensated by slanting the second virtual line opposite to the slant of the first virtual line. In Figure 3, the first and second virtual lines are drawn perpendicular to the transmission lines, with the understanding that it is not a limitation.

Note that Figure 3 is especially schematic in the first and second starting and/or terminating portions, e.g., in between the first starting point 151 and first bend 156, and/or in between second bend 108 and second termination point 103, etc. The transmission lines may have other bends which are not indicated, etc. First transmission line 152 and second transmission line 102 are indicated with a line, but in practical use they typically have some width. The lines which indicate the transmission lines in Figure 3 can be taken to be the midlines, or the edges of transmission lines. For example, these lines may be expanded as shown in Figures 1, 2, 4, 5, and/or 6, or in any other suitable way.

Each of the multiple transmission lines has an electrical length, measured from its starting point to its terminating point, the electrical lengths being equal. This has the advantage, that relative phase differences between signals which are placed on the starting points, such as opposite phase, or no phase difference, are preserved at the terminating points.

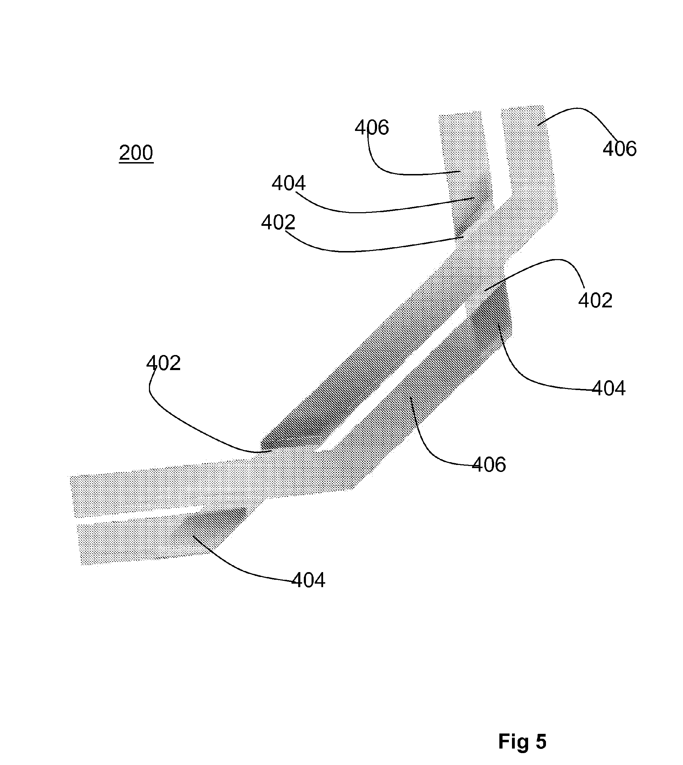

First transmission line 152 and second transmission line 102 cross each other in a crossing point 120. Crossing two or more transmission lines may be done in any convenient manner known in the art. One example of a crossing is explicated in the description of Figure 5. Preferably, at crossing point 120, transmission lines 102 and transmission line 152 do not make electrically conducting contact with each other.

Note that in figure 3 the transmission lines when regarded as a whole also bend and make an angle, although the order of the transmission lines may change. Note that in Figure 3, when seen from the crossing point, the order of the transmission lines reverses; at the starting points, before crossing point 120, the order is second transmission lines 102 then first transmission line 152, but at the terminating points, after crossing point 120, the order is first transmission line 152 then second transmission lines 102.

In Figure 3, second transmission line 102 and first transmission line 152 make a third angle 126 at crossing point 120. In Figure 3, third angle 126 is of the same size and orientation as second angle 124 and first angle 122.

Preferably, the distance between the transmission lines is kept constant, in the starting and terminating portions. This simplifies, e.g., the layout of the transmission lines. In figure 3, first transmission line 152 and second transmission line 102, between the starting points 101, 151, and first bend 156 and second bend 108, are placed at a first distance 132. In figure 3, first terminating portion 159 and second terminating portion 109, between the terminating points 153, 103 and first bend 156 and second bend 108, are placed at a second distance 134. Preferably, second distance 134 and first distance 132 are equal. The invention may be applied without this condition, for example, by introducing a further bend in first transmission line 152 at crossing point 120, and/or having angle 122 different from angle 124. In this description, we will for simplicity assume that first distance 132 is equal to second distance 134, with the understanding that this is not limiting.

In Figure 3, first bend 156 lies somewhere between first starting point 151 and crossing point 120 on first transmission line 152. Second bend 108 lies somewhere between second termination point 103 and crossing point 120 on second transmission line 102. One way of assuring that the crossing 120 is done without introducing a length difference in the transmission lines is by ensuring that a further first distance between the first bend 156 and the crossing point 120 is substantially equal to a further second distance between crossing point 120 and second bend 108.

One way of ordering the various points and line segments, i.c., the ordering shown in Figure 3, is as follows. On first transmission line 152, the following elements appear preferably in this order: first starting point 151, first starting portion 154, first bend 136, crossing point 120, first terminating portion 158, and first terminating point 153. On second transmission line 102, the following elements appear preferably in this order: second starting point 101, second starting portion 104, crossing point 120, second bend 108, second terminating portion 109 and second terminating point 103.

Below it is proven, for the specific configuration shown in Figure 3 that the lengths of second transmission line 102 and first transmission line 152 are equal. Note that this may also be proven for other arrangements, and that this proof is for illustration only, and does not limit the invention in any way.

First, a number of helpful imaginary points and lines are introduced. Through first bend 156 an imaginary line is drawn, perpendicular to first starting portion 154 which crosses second starting portion 104 in a second foot 106. Through second bend 108 an imaginary line is drawn, perpendicular to second terminating portion 109 which crosses first terminating portion 159 in a first foot 158.

The parts of second transmission line 102 and first transmission line 152 which are bounded by the starting points and second foot 106 and first bend 156 are equal in length, as they form the opposite sides of a rectangle. It is known in the art that opposite sides of a rectangle are equal in length. Similarly, the parts of second transmission line 102 and first transmission line 152 which are bounded by the terminating points and second bend 108 and first foot 158 are also equal in length.

It remains to be proven that the line segment from first bend 156 to first foot 158 is equal in length to the line segment from second foot 106 to second bend 108. A first imaginary triangle is formed by the points: first bend 156, second foot 106 and crossing point 120. A second imaginary triangle is formed by the points: second bend 108, first foot 158 and crossing point 120. Since the two triangles each have an angle of equal size, namely third angle 126. Moreover, since both triangles comprise the foot of a perpendicular side, the triangles are right-angled triangles

Also the two triangles each have a side of equal length, in particular, the line segment running from first bend 156 to crossing point 120 is of equal length to the corresponding line segment running from crossing point 120 to second bend 108.

It is known in the art that two right-angled triangles which have both an additional equal angle and an equal side are congruent; hence the first triangle is congruent with the second triangle. It follows that the line segment from second foot 106 to crossing point 120 is equal in length to the line segment from crossing point 120 to first foot 158. Since the two parts which partition the line segment from first bend 156 to first foot 158 are equal to the two parts that partition the line segment from second foot 106 to second bend 108, these two line segments are of equal length.

It follows that second transmission line 102 and first transmission line 152 are of equal length, making these transmission lines advantageous for use in the transport of multiple related signals, e.g. differential signals, and parallel signals, etc.

A transmission layout according may be designed as follows: Bend first transmission line 152 over first angle 122. Determine the crossing point 120 of the first transmission line 152 with second transmission line 102. Determine the electrical length of the segment between first bend 156 and crossing point 120. Determine a point on second transmission line 102 after crossing point 120 at the electrical length. At this point, bend second transmission line 102 over the same angle.

Figure 3 shows the transmission lines bending upwards, but the transmission lines may also bend downwards; an example may be obtained by reflecting Figure 3 over a horizontal line.

First angle 122, second angle 124 and third angle 126 may be of any size. Preferably, the size is larger than 0 degrees but smaller than 90 degrees, the orientation may be either way. In particular, if electronic system 100 uses deep submicron IC processes, the angle is advantageously 45°. Other convenient angles include, e.g., 15, 22.5, 30, 45, 60, 75, 90 degrees, etc. Note that 90 degrees is a right angle, and is equal to Pi/2 rad.

These angles can be combined in various ways when two or more multiple crossing are combined in a further electronic circuit. By bending the transmission lines first over a first angle and next over a second angle, a total bending is obtained equal to the sum of the first and second angle. For example, a total bending over 90 degree can obtained, by bending the transmission lines twice over 45 degree; by bending thrice over 30 degrees; by bending once over 30 and once over 60 degrees, etc.

In **Figure 3a,** a schematic top view of an electronic circuit 300 is shown with three transmission lines: second transmission line 102, first transmission line 152 and third transmission line 302. The configuration of second transmission line 102 and first transmission line 152 relative to each other is the same as in Figure 3. To enhance the simplicity of the drawing some of the reference numerals and imaginary lines of Figure 3 are omitted in Figure 3a.

Third transmission line 302 at its starting point runs parallel to first transmission line 152 and second transmission line 102. Third transmission line 302 has a third bend, where third transmission line 302 makes a third angle 322. Third angle 322 is preferably of the same size and orientation as first angle 122 and second angle 124. Third transmission line 302 crosses first transmission line 152 in a first further crossing point 306, and second transmission line 102 in a second further crossing point 307. Preferably, a third distance 332 between first transmission line 152 and third transmission line 302 at the starting points is equal to a further third distance 334, between third transmission line 302 and first transmission line 152 at the terminating points. Preferably, the distance 332 is equal to distance 132 and distance 134 is equal to distance 334.

In Figure 3a, second transmission line 102, first transmission line 152 and third transmission line 302 are of equal (electrical) length. This can be seen by, e.g., by noting that first transmission line 152 and third transmission line 302 have a similar geometrical configuration as the second transmission line 102 and the first transmission line 152.

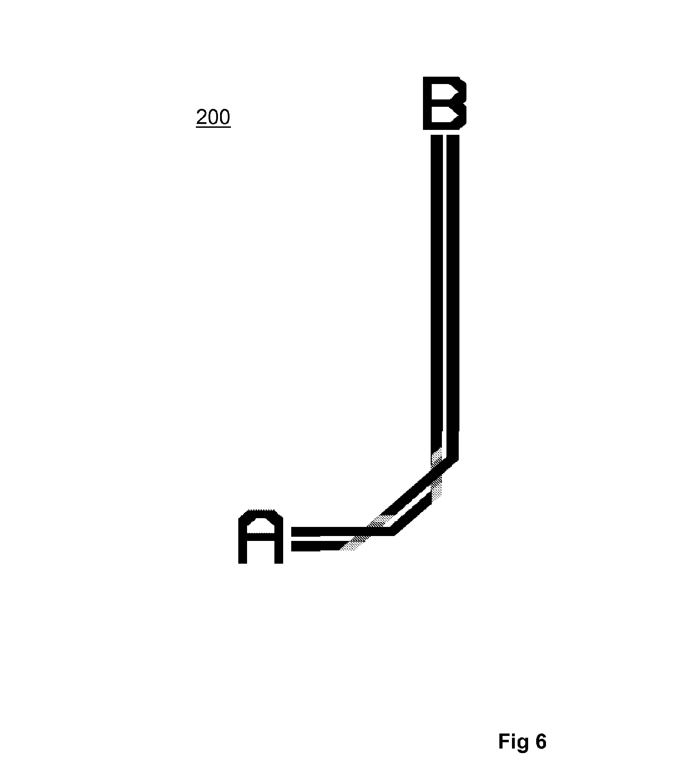

In **Figure 4** is a top view of at least part of further electronic system 200. **Figure 5** is a perspective view of electronic system 200. **Figure 6** shows a top view of electronic system 200 on a larger scale.

Electronic system 200 shows how crossings may be applied in the example shown in Figure 1 and 2, two crossing according to the invention are combined. Each of the crossings bend the transmission lines '1' and '2' over 45 degrees.

Using two crossings of each 45 degrees is one way of bending transmission lines over, in total, 90 degrees. There are advantages to using two bends of each 45 degree over using one of 90 degrees. First of all it allows more possibilities in the layout during the optimization of the layout, hence a likely a better layout will result. Second, each of the transmission lines crosses once over the other, and once under the other. This makes the two transmission lines even more like each other, which further reduces the phase shifting introduced in the system by the transmission lines.

The crossing of the transmission lines may use two levels of metal. A first level, e.g., an upper metal level 406, and may be used to make the body of the transmission lines. Another level, e.g., a bottom metal level 402, may be used to make an underpass. The upper metal level 406 is connected with the under metal level 402 by level connectors 404. Preferably, the metal levels and connectors are conductors and the substrate (not shown) in which the transmission lines are embedded is an isolator.

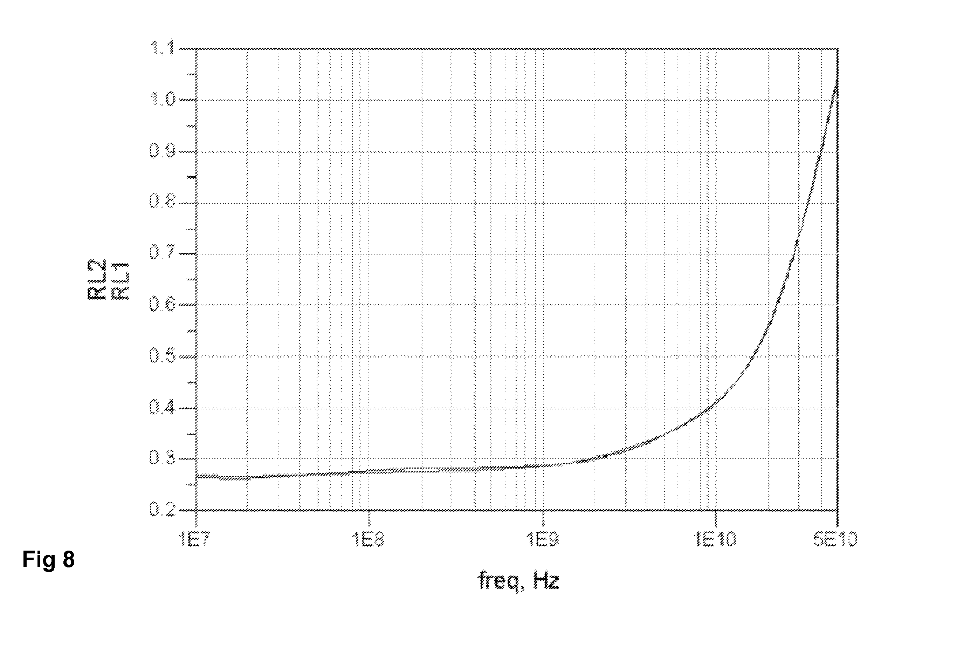

**Figure 7 and 8** are graphs that show simulation results, illustrating the effect of the invention. The horizontal axis of the graphs represent the frequency of a test signal which is send over the two transmission lines '1' and '2'. The horizontal axis uses a logarithmic scale and uses the unit Hertz. The vertical axis represents simulated electrical resistance in ohms.

Figure 7 shows simulation results for the electronic system illustrated in Figure 1 and 2. In Figure 7 the line indicated with 'RL1' indicates the simulation results for transmission line '1' and the line indicated with 'RL2' indicates the simulation results for transmission line '2'. Note that the the 'RL1' graphs lies above the 'RL2' graph for all frequencies. Both graphs rise with increasing frequency, i.e., the electrical resistance of the transmission lines rises with the frequency of the used signal. At around $2 \times 10^9$ Hertz, both graphs show a sharp increase, which is due to the proximity effect as well as to the skin effect occurring in the material.

Figure 8 shows the results of a similar simulation done for the electronic system shown in Figure 4, 5, and 6. Note that the two graphed lines in Figure 8 are nearly identical. Especially for higher frequencies, the two graphs coincide.

Identical electrical resistance indicates that the transmission lines will not introduce a phase shift, for signals transmitted on the two transmission lines '1' and '2'. Simulation results show that both transmission lines present the same electrical resistance. In a lossy transmission line, there are four types of losses:

- conductor losses
- dielectric losses
- radiation losses
- leakage losses

Losses are converted to and from series resistances with equation

$$\alpha \cong \frac{R_{series}}{2 \times Z_o} \text{ (first approximation)}$$

Wherein $\alpha$ represents the losses, $Z_o$ the characteristic impedance of the line and $R_{series}$ the serial resistance.

So having the same resistance on each line will lead to the same attenuation of the signal on each signal line, keeping in mind that the electrical lengths are also the same, and so no additional phase between both lines is introduced.

It should be noted that the above-mentioned embodiments illustrate rather than limit the invention, and that those skilled in the art will be able to design many alternative embodiments without departing from the scope of the appended claims. In the claims, any reference signs placed between parentheses shall not be construed as limiting the claim. Use of the verb "comprise" and "include" and its conjugations do not exclude the presence of elements or steps other than those stated in a claim. The article "a" or "an" preceding an element does not exclude the presence of a plurality of such elements. The invention may be implemented by means of hardware comprising several distinct elements. In a system/device/apparatus claim enumerating several means, several of these means may be embodied by one and the same item of hardware. The mere fact that certain measures are recited in mutually different dependent claims does not indicate that a combination of these measures cannot be used to advantage.

**Claims**

1. An electronic circuit (100), having multiple transmission lines (152, 102), supported by a substrate, for transport of information in the form of multiple interrelated signals across the electronic circuit, wherein:

   a first transmission line (152) of the multiple transmission lines has a first starting point (151), a first terminating point (153), and a first bend (156) where the first transmission line makes a first angle (122),
   a second transmission line (102) of the multiple transmission lines has a second starting point (101), a second terminating point (103), and a second bend (108) where the second transmission line makes a second angle (122)
   the first and second angle have the same magnitude and the same orientation with respect to the substrate,
   the first and second transmission lines run parallel at the first and second starting points, and run parallel at the first and second terminating points, **characterized in that**
   the first transmission line (152) crosses the second transmission line (102), and electrical lengths of the first and second transmission lines are equal.

2. An electronic circuit as in Claim 1, wherein a first virtual line running through the first and second starting points is substantially perpendicular to the multiple transmission lines at the first and second starting points, and/or a second virtual line running through the first and second terminating points, is substantially perpendicular to the multiple transmission lines at the first and second terminating points.

3. An electronic circuit as in any one of the preceding claims, wherein a first distance (132) between the first transmission line and the second transmission line, measured where the first and the second transmission line run substantially parallel at the first and second starting points, is substantially equal to a second distance (134) between the first transmission line and the second transmission line, measured where the first and second transmission line run substantially parallel at the first and second terminating points.

4. An electronic circuit as in any one of the preceding claims, wherein the first transmission (152) line crosses the second transmission line (102) at a crossing point (120), and wherein the first bend (156) is between the first starting point and the crossing point (120), and wherein the second bend (108) is between the crossing point (120) and the second terminating point.

5. An electronic circuit as in Claim 4, wherein a further first electrical length between the first bend and the crossing point is equal to a second electrical length between the crossing point and the second bend.

6. An electronic circuit as in any one of the preceding claims, wherein the first and second angles (122, 124) are equal to 45 degrees.

7. A further electronic circuit (200) comprising a first electronic circuit as in any one of the preceding claims and a second electronic circuit as in any one of the preceding claims, the first and second electronic circuit having the same substrate, wherein the first and second terminating points of the multiple transmission lines in the first electronic circuit are the same as the first and second starting points of the multiple transmission lines in the second electronic circuit.

8. A further electronic circuit as in Claim 7, wherein the multiple transmission lines running substantially parallel at their first and second starting points in the first electronic circuit are being placed at a substantially right angle with the multiple transmission lines running substantially parallel at their first and second terminating points in the second electronic circuit.

9. A further electronic circuit as in Claim 7 or 8, wherein

   the first transmission line and the second transmission line in the first electronic circuit are connected to the first transmission line and the second transmission line in the second electronic circuit, respectively, and
   wherein, in the first electronic circuit, the first transmission line crosses over the second transmission line, and wherein, in the second electronic circuit, the second transmission line crosses over the first transmission line.

10. Multiple transmission lines suitable for use in an electronic system and/or further electronic system as in

**EP 2 317 600 A1**

any one of the preceding claims.

**Fig 1**

Fig 2

**Fig 3**

EP 2 317 600 A1

300

302

334

152

102

102

132

307

152

306

120

156

122

108

124

302

332

322

134

**Fig 3a**

EP 2 317 600 A1

200

404

406

404

402

404

2

1

402

404

**Fig 4**

200

406

404

402

402

402

404

406

404

**Fig 5**

200

B

A

Fig 6

**Fig 7**

Fig 8

EP 2 317 600 A1

**EUROPEAN SEARCH REPORT**

Application Number

EP 09 17 4761

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | DE 29 43 502 A1 (PHILIPS NV) 14 May 1980 (1980-05-14) * page 15, line 20 - page 16, line 1 * * figures 5,6 * | 1-6,10 | INV. H01P1/02 H01P3/04 H01P3/02 H05K1/02 |
| X | DE 43 26 989 A1 (SIEMENS AG [DE]) 24 March 1994 (1994-03-24) * column 2, line 36 - column 3, line 29 * * figure 1 * | 1-3,6,10 | |
| X | US 2004/212537 A1 (MOHAMMADIAN ALIREZA HORMOZ [US]) 28 October 2004 (2004-10-28) * abstract * * paragraphs [0016] - [0021] * | 1-3,6,10 | |
| A | EP 1 655 800 A1 (ATMEL GERMANY GMBH [DE]) 10 May 2006 (2006-05-10) * abstract * * paragraphs [0007] - [0009] * * figures 1,2 * | 1-10 | |
| A | US 2009/204934 A1 (LIN YU-SEN [TW]) 13 August 2009 (2009-08-13) * paragraphs [0017] - [0019]; figures 3A-3C * | 1-10 | TECHNICAL FIELDS SEARCHED (IPC) H01P H05K |
| A,D | US 2007/063782 A1 (KANNO HIROSHI [JP] ET AL) 22 March 2007 (2007-03-22) * abstract * * paragraphs [0074] - [0082] * | 1-10 | |

The present search report has been drawn up for all claims

| Place of search | Date of completion of the search | Examiner |
|---|---|---|
| Munich | 29 January 2010 | van Norel, Jan |

EPO FORM 1503 03.82 (P04C01)

## ANNEX TO THE EUROPEAN SEARCH REPORT
## ON EUROPEAN PATENT APPLICATION NO.

EP 09 17 4761

This annex lists the patent family members relating to the patent documents cited in the above-mentioned European search report.
The members are as contained in the European Patent Office EDP file on
The European Patent Office is in no way liable for these particulars which are merely given for the purpose of information.

29-01-2010

| Patent document cited in search report | | Publication date | Patent family member(s) | | Publication date |
|---|---|---|---|---|---|
| DE 2943502 | A1 | 14-05-1980 | BE | 879781 A1 | 30-04-1980 |
| | | | CA | 1164966 A1 | 03-04-1984 |
| | | | FR | 2440627 A1 | 30-05-1980 |
| | | | GB | 2038564 A | 23-07-1980 |
| | | | IT | 1124893 B | 14-05-1986 |
| | | | JP | 60035804 A | 23-02-1985 |
| | | | JP | 61017161 B | 06-05-1986 |
| | | | JP | 1285505 C | 09-10-1985 |
| | | | JP | 55070102 A | 27-05-1980 |
| | | | JP | 60006567 B | 19-02-1985 |
| | | | NL | 7810942 A | 07-05-1980 |
| | | | SE | 435434 B | 24-09-1984 |
| | | | SE | 7909016 A | 04-05-1980 |
| | | | US | 4383227 A | 10-05-1983 |
| DE 4326989 | A1 | 24-03-1994 | NONE | | |
| US 2004212537 | A1 | 28-10-2004 | WO | 2004097985 A1 | 11-11-2004 |
| EP 1655800 | A1 | 10-05-2006 | DE 102005038456 A1 | | 04-05-2006 |
| | | | US | 2006091973 A1 | 04-05-2006 |
| US 2009204934 | A1 | 13-08-2009 | NONE | | |
| US 2007063782 | A1 | 22-03-2007 | CN | 101010830 A | 01-08-2007 |
| | | | CN | 101010831 A | 01-08-2007 |
| | | | WO | 2007000933 A1 | 04-01-2007 |
| | | | WO | 2007000934 A1 | 04-01-2007 |
| | | | JP | 3954640 B2 | 08-08-2007 |
| | | | JP | 3954641 B2 | 08-08-2007 |
| | | | US | 2007063783 A1 | 22-03-2007 |
| | | | US | 2008116989 A1 | 22-05-2008 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20070063782 A